# EUROPEAN PATENT SPECIFICATION

(11) **EP 1 917 306 B1**
(45) Date of publication and mention of the grant of the patent: **28.04.2010**
(21) Application number: 06700328.5
(22) Date of filing: 02.01.2006
(51) Int. Cl.: C08L 55/02, C08L 33/06

(54) **FLAME RETARDANT POLYMER COMPOSITIONS**
FLAMMWIDRIGE POLYMERZUSAMMENSETZUNGEN
COMPOSITIONS POLYMERIQUES IGNIFUGES

(30) Priority: 26.08.2005 KR 20050078815
(43) Date of publication of application: 07.05.2008
(73) Proprietor: Cheil Industries Inc., Kumi-Si, Gyeongsangbuk-do 730-030 (KR)
(72) Inventor: KIM, Dong Jin, Gyeonggi-Do 435-010 (KR); SON, Se Bum, Seoul 158-092 (KR); AHN, Sung Hee, Seoul 132-020 (KR); CHOI, Jin Hwan, Gyeonggi-Do 431-760 (KR)
(74) Representative: Troesch Scheidegger Werner AG
(86) International application number: PCT/KR2006/000010
(87) International publication number: WO 2007/024044

(56) References cited:
- JP-A- 08 199 055
- JP-A- 09 143 321
- JP-A- 52 016 556
- US-A- 4 472 554
- US-A- 5 681 875

## Description

### TECHNICAL FIELD

The invention relates to flame retardant polymer compositions, particularly those comprising a rubber-modified styrenic copolymer resin, an ethylene-alkyl (meth)acrylate copolymer resin, and a flame retardant compound. It is also relates to molded articles and the use of the polymer composition in electronic devices.

### PRIOR ART

Acrylonitrile-butadiene-styrene copolymer (hereinafter "ABS") resin has good mechanical strength and excellent appearance, and thus, is widely used in the production of internal and external parts for many electronic and non-electronic devices. ABS resin has no fire resistance in itself, and when set on fire by an external ignition factor, the resin serves as an energy source aiding combustion to continue the spread of the fire. For this reason, countries, including the United States and many European countries, have regulations requiring that only flame retardant resins be used in the production of molded parts for the internal and external parts of electronic products in order to ensure fire safety.

Methods for imparting flame retardancy to ABS resin are various. Some methods comprise adding a halogen-containing organic compound as a flame retardant and optionally adding an antimony oxide-containing inorganic compound as a flame retardant aid. However, bromine-containing organic compound generally worsen the physical properties of the resin itself, such as thermal stability, impact resistance strength, weather resistance, thermal resistance and processability.

Another example of imparting flame-retardancy to ABS is disclosed in Korean Patent Application No. 10-2003-0029935. This reference discloses an ABS copolymer with an antimony-based flame retardant. However, the disclosed compound, like the bromine-containing organic compounds, has poor impact resistance and poor processability as measured by it melt index. Thus, a method for imparting excellent flame retardancy, while maintaining the physical properties of the ABS resin, is still needed.

Various attempts have been made to improve the flowability and impact strength of resin compositions containing a flame-retardant ABS resin. These attempts have included modifying the molecular weight of the ABS resin, adding impact modifiers to the ABS resin, and controlling the particle size distribution of the resin. However, no composition has been devised to maintain flowability or impact strength without sacrificing one or more physical properties of the ABS resin. Typically, increases in flowability of the composition results in a decrease in the impact strength, and vice versa.

One attempt at provided an improved ABS composition is disclosed in International Application No. PCT/US03/15101, published as WO 03/097743. This reference discloses an ABS copolymer mixed with a polycarbonate and an ethylene/acrylate ester copolymer. The reference further discloses that a flame retardant agent could be used. However, the polycarbonate would not be expected to be stable in combination with certain of the more effective flame retardants.

### DISCLOSURE OF THE INVENTION

One aspect of the present invention relates to a polymer composition. The polymer composition includes a rubber-modified styrenic copolymer resin; an ethylene-alkyl (meth)acrylate copolymer resin; and a flame retardant agent comprising an antimony compound. In one embodiment of this aspect of the invention, the ethylene-alkyl (meth)acrylate copolymer resin comprises a polymer represented by Formula (I): 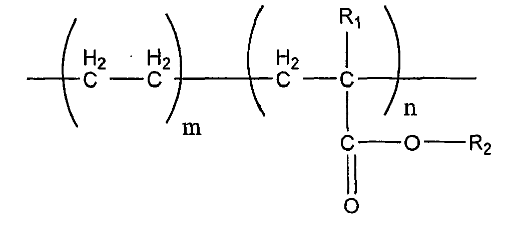 in which R₁ is hydrogen or methyl, R₂ is hydrogen, methyl, ethyl, propyl, isopropyl, butyl, sec-butyl, t-butyl, isobutyl, isoamyl, or t-amyl, and the ratio of m to n ranges from about 300:1 to about 10:90.

The ethylene-alkyl (methyl) acrylate copolymer can be made from at least one monomer selected from the group consisting of acrylate, methyl acrylate, ethyl acrylate, propyl acrylate, isopropyl acrylate, butyl acrylate, sec-butyl acrylate, t-butyl acrylate, isobutyl acrylate, isoamyl acrylate, and t-amyl acrylate, methacrylate, methyl methacrylate, ethyl methacrylate, propyl methacrylate, isopropyl methacrylate, butylmethacrylate, sec-butyl methacrylate, t-butylmethacrylate, isobutyl methacrylate, isoamyl methacrylate, t-amyl methacrylate, and combinations thereof.

In certain preferred embodiments of the polymer composition, the polymer composition is substantially free of a polycarbonate. However, the composition can include a polycarbonate up to about 15% with reference to the total weight of the composition, more preferably less than about 5% with reference to the total weight of the composition.

The composition can further includes a chlorinated organic compound as an impact modifier. For example, polyvinyl chloride, chlorinated polyethylene, and combinations thereof can serve as impact modifiers. The composition according to the invention includes a rubber-modified styrenic copolymer resin in about 100 parts by weight, an ethylene-alkyl (meth)acrylate copolymer resin from about 0.1 to about 30 parts by weight, the impact modifier from about 1 to about 10 parts by weight, and the flame retardant agent from about 1 to about 25 parts by weight.

Any of a number of flame retardant agents can be used, including tetrabromobisphenol A, bis(tribromophenoxy) ethane, brominated epoxy resin, brominated epoxy resin terminated with tribromophenol, and combinations thereof.

Another aspect of the invention relates to a molded article made of the polymer composition described above. In preferred embodiments, the molded article has flame retardancy V-0 when a specimen of the composition is tested according to UL-94 flame retardant standards for a specimen thickness of 1/12". The molded article preferably has an impact strength of at least about 19 kg·cm/cm, more preferably at least about 23 kg·cm/cm, and still more preferably at least about 25 kg·-cm/cm when a specimen of the composition is tested according to the standard ASTM D256 (1/8" notched) at 23 °C. Another preferred characteristic of the molded article, is the use of the polymer composition having a melt index of at least 14 g/10 minutes, more preferably at least 15 g/10 minutes, when a specimen of the composition is tested according to the standard ASTM D-1238 (200 °C and 5 kg). Still another preferred attribute of the molded article is that the polymer composition has a Vicat softening point temperature of at least about 84 °C when a specimen of the composition is tested according to ASTM D1525 at a load of 5 kg and a rate of 50°C/hr.

Another aspect of the present invention relates to a method of making a plastic structure using the composition described above. This method includes molding the polymer composition into a desired shape.

Yet another aspect of the invention relates to the use of the polymer composition in an electronic device. This method includes providing an electronic circuit; and providing a housing substantially enclosing the electronic circuit. The housing includes at least a portion made of the polymer composition described above.

One more aspect of the present invention relates to the use of the polymer composition in an electronic device that includes a housing, in which the housing comprises at least a portion made of the polymer composition described above.

### BEST MODES FOR CARRYING OUT THE INVENTION

The present inventors have discovered a highly flame retardant ABS resin with enhanced physical and mechanical properties including both excellent flowability and impact strength, and the molds and electronic parts of using the same novel resin. As noted above, one aspect of this invention relates to a polymer composition. According to certain of the various embodiments of such a polymer composition, the composition can comprise a rubber-modified styrenic copolymer resin, an ethylene-alkyl (meth)acrylate copolymer resin, and a flame-retardant agent comprising an antimony compound. Some embodiments also comprise an impact modifying chlorinated polymer. The molded articles of the embodiments show enhanced physical or mechanical properties as compared to other compositions less one or more components. The molded articles of the embodiments also maintain their flowability and thermal stability even with the addition of halogen containing flame retardants. As will be discussed, the molded compositions according to embodiments of the invention have good impact strength and flame retardancy while maintaining excellent thermal stability and processability.

In some embodiments, the polymer composition or a molded article of the polymer composition, which comprises rubber-modified styrenic copolymer resin, an ethylene-alkyl (meth)acrylate copolymer resin, a flame retardant agent comprising antimony, has flame retardancy V-0 when a specimen of the composition is tested according to UL-94 flame retardant standards for a specimen thickness of 1/12".

In one embodiment, the molded article, which comprises rubber-modified styrenic copolymer resin, an ethylene-alkyl (meth)acrylate copolymer resin, and a flame-retardant agent comprising antimony, has an enhanced impact strength of at least about 19 kg·cm/cm when a specimen of the article is tested according to the standard ASTM D256 (1/8" notched) at 23 °C. In another embodiment, the molded article has an enhanced impact strength of at least about 23 kg·cm/cm when a specimen of the article is tested according to the standard ASTM D256 (1/8" notched) at 23 °C. In another embodiment, the molded article has an enhanced impact strength of at least about 25 kg·cm/cm when a specimen of the article is tested according to the standard ASTM D256 (1/8" notched) at 23°C.

In some of these embodiments, the molded article, which comprises an rubber-modified styrenic copolymer resin, an ethylene-alkyl (meth)acrylate copolymer resin, and a flame-retardant agent comprising antimony, has a melt index of at least 14 g/10 minutes when a specimen of the composition is tested according to the standard ASTM D-1238 (200 °C and 5 kg). Furthermore, some embodiments have a melt index of at least 15 g/10 minutes when a specimen of the composition is tested according to the standard ASTM D-1238 (200 °C and 5 kg).

In some of the embodiments of the present invention, the molded article comprises a rubber-modified styrenic copolymer resin, an ethylene-alkyl (meth)acrylate copolymer resin, an impact modifying chlorinated polymer, and a flame-retardant halo gen containing compound.

Certain particular embodiments advantageously provide a flame retardancy of the molded article of V-0. Other embodiments, provide a flame retardancy of V-I. Other embodiments of the present invention have the advantage of having a Vicat softening point temperature of at least about 84 °C when a specimen of the composition is tested according to ASTM D1525 at a load of 5 kg and a rate of 50 °C/hr. In many such embodiments, the softening temperature is about 84-85°C.

In some embodiments, a polymer composition for making a molded article comprises comprises an acrylonitrile-butadiene-styrene (ABS) copolymer resin, an ethylene-alkyl (meth)acrylate copolymer resin, an impact modifying chlorinated polymer, and a flame-retardant halogen containing compound. According to embodiments, the polymer composition may contain one or more compounds or polymers in addition to the foregoing components. Additional components or additives may be added to provide additional properties or characteristics to the polymer composition or to modify existing properties of the composition. In some embodiments, the polymer composition further comprises antimony oxide. For example, an inorganic filler such as glass fiber, carbon fiber, talk, silica, mica, and alumina may be added to improve mechanical strength and heat distortion temperature of the resin composition. In addition, the polymer composition may further include a heat stabilizer, an anti-oxidant, an ultraviolet absorbing agent, a light stabilizer, a flame retardant, a lubricant, a pigment and/or dye. One of ordinary skill in the art will appreciate that various additives may be added to the polymer compositions according to embodiments of the invention.

For some embodiments, the polymer compositions are prepared by mixing their components including rubber-modified styrenic copolymer resin, an ethylene-alkyl (meth)acrylate copolymer resin, and a flame-retardant agent comprising an antimony compound. In some embodiments, one or more other additives may be mixed together with the components of the polymer composition. In some embodiments, one or more component resins may be heated to melt prior to the mixing or the composition may be heated during the mixing. The mixing may occur when each components is in a solid, liquid, or dissolved state, or mixtures thereof. In one embodiment, the above components are mixed together all at once. Alternatively, one or more components are added individually. For example, an ABS copolymer resin may first be mixed with the impact modifier, prior to mixing this admixture with the remaining components. Formulating and mixing the components may be made by any method known to those persons having ordinary skill in the art, or those methods that may be later discovered. The mixing may occur in a pre-mixing state in a device such as a ribbon blender, followed by further mixing in a Henschel mixer, Banbury mixer, a single screw extruder, a twin screw extruder, a multi screw extruder, or a cokneader.

In some embodiments, the polymer composition may comprise 100 parts by weight of an acrylonitrile-butadiene-styrene copolymer resin consisting of 5-30% by weight of acrylonitrile, 5-30% by weight of butadiene rubber and 40-90% by weight of styrene; 0.1-30 parts by weight of an ethylene/alkyl(meth)acrylate copolymer; 5-30 parts by weight of a flame retardant compound; 1-15 parts by weight of antimony oxide; and 1-10 parts by weight of a chlorinated organic compound.

Another embodiment provides a molded article using the polymer composition according to the foregoing embodiments. The polymer compositions are molded into various shapes. For molding with the composition, an extrusion molding machine such as a vented extruder may be used. The polymer composition of embodiments may be molded into various moldings using, for example, a melt-molding device. In embodiments, the polymer composition is formed into a pellet, which then may be molded into various shapes using, for example, injection molding, injection compression molding, extrusion molding, blow molding, pressing, vacuum forming or foaming. In one embodiment, the polymer composition can be made into a pellet using melt-kneading, and the resulting pellets are molded into moldings through injection molding or injection compression molding.

As noted, in one embodiment, the polymer compositions are formed into pellets. In other embodiments, the polymer compositions are formed into structural parts of various consumer products, including electronic devices and appliances. In some embodiments, the polymer compositions are molded into a housing or body of electronic or non-electronic devices. Examples of electrical devices in which a molded article made of the blend of the composition according to embodiments of the invention include printers, computers, word processors, keyboards, personal digital assistants (PDA), telephones, mobile phones, facsimile machines, copy machines, electronic cash registers (ECR), desk-top electronic calculators, PDAs, cards, stationery holders, washing machines, refrigerators, vacuum cleaners, microwave ovens, lighting equipment, irons, TV, VTR, DVD players, video cameras, radio cassette recorders, tape recorders, mini disc players, CD players, speakers, liquid crystal displays, MP3 players, and electric or electronic parts and telecommunication equipment, such as connectors, relays, condensers, switches, printed circuit boards materials, coil bobbins, semiconductor sealing materials, electric wires, cables, transformers, deflecting yokes, distribution boards, clocks, watches, and the like.

Another embodiment provides an electronic device which includes a housing or a part, which is made of a polymer composition comprising rubber-modified styrenic copolymer resin, an ethylene-alkyl (meth)acrylate copolymer resin, and a flame-retardant agent comprising an antimony compound.

### Rubber-modified Styrenic Copolymer Resin

In many embodiments of the present invention, the polymer composition comprises a rubber-modified styrenic copolymer resin. For these embodiments, a preffered rubber-modified styrenic copolymer resin is an ABS copolymer resin. In certain of these embodiments, the ABS copolymer resin can include a graft copolymer obtained by graft copolymerizing a styrene monomer and an acrylonitrile monomer with a rubber.

Examples of the rubber can be selected from the group consisting of butadiene-type rubber, isoprene-type rubber, a copolymer of butadiene and styrene, and alkylacrylate rubber, and a copolymer obtained by copolymerizing a styrene monomer and an acrylonitrile monomer. A preferred rubber is butadiene.

In some embodiments, the rubber-modified styrenic copolymer resin can be an aromatic vinylic monomer reacted with another monomer. In some of these embodiments, a SAN copolymer is used as the styrenic polymer, which may be grafted onto the rubber. In embodiments, the SAN copolymer may have an acrylonitrile content of about 20 percent to about 40 percent by weight and a styrene content from about 60 to about 80 percent by weight.

The synthesis of styrenic copolymers is well known in the art. In embodiments in which the styrenic copolymer is SAN, the weight average molecular weight (M_{w}) of the SAN copolymer resin is from about 80,000 to about 200,000. The weight average molecular weight of the styrene acrylonitrile copolymer may be 80,000, about 85,000, about 90,000, about 100,000, about 110,000, about 120,000, about 130,000, about 140,000, about 150,000, about 160,000, about 170,000, about 180,000, about 190,000, and 200,000.

In some embodiments, the SAN copolymer is reacted with a butadiene core. The skilled artisan will appreciate the many syntheses of rubber-modified styrenic resins. For example, ABS copolymer resins can be synthesized in many ways. In some embodiments, the styrene-acrylonitrile (SAN) copolymer may not completely react with the butadiene core, thus leaving remaining unreacted SAN copolymer which may form at least one additional matrix. In certain embodiments, an ABS resin may comprise from about 5 to about 30 percent by weight of rubber and from about 70 percent to about 95 percent by weight of a SAN copolymer. In some embodiments, the ABS resin comprises acrylonitrile from about 5 to about 30 percent by weight, butadiene rubber from about 5 percent to about 30 percent, and styrene from about 40 percent to about 90 percent by weight.

The rubber-modified styrenic copolymer system is very flexible and can be tailored to needs based upon the monomer systems. For example, ABS resins may be tuned by the selection of the styrene-acrylonitrile copolymer matrix and a styrene butadiene copolymer. At times, both a matrix and a dispersed phase are operative in some embodiments. The amount of grafting between the matrix and the dispersed phases may vary with the appropriate application.

### Ethylene-Alkyl (Meth)Acrylate Copolymer Resin

In particular embodiments of the present invention, the ethylene-alkyl (meth)acrylate copolymer is a copolymer of an olefin monomer and an alkyl (meth)acrylate monomer. Olefins or olefin monomers, also called alkenes, are unsaturated hydrocarbons whose molecules contain one or more pairs of carbon atoms linked together by a double bond. Examples of polyolefins are polyethylene, polypropylene, polyisopropylene, polybutalene, etc. In some embodiments, ethylene is used as an olefin monomer. In other embodiments, mixtures of the olefins may be used as monomers.

The alkyl (meth)acrylate monomer used in these embodiments may be a methacrylate monomer or an acrylate monomer. In some embodiments, these monomers may be substituted in any fashion. Examples include, but are not limited to, methyl acrylate, ethyl acrylate, propyl acrylate, isopropyl acrylate, butyl acrylate, sec-butyl acrylate, t-butyl acrylate, isobutyl acrylate, isoamyl acrylate, and t-amyl acrylate. Other embodiments may use the monomers methyl methacrylate, ethyl methacrylate, propyl methacrylate, isopropyl methacrylate, butylmethacrylate, sec-butyl methacrylate, t-butylmethacrylate, isobutyl methacrylate, isoamyl methacrylate, and t-amyl methacrylate.

The olefin and alkyl (meth)acrylate monomers may be reacted together to form an olefin-akyl (meth)acrylate copolymer resin. In some embodiments, ethylene monomers and alkyl (meth)acrylate monomers may be reacted together to form ethylene-alkyl (meth) acrylate monomers. The syntheses of copolymers of olefin and alkyl (meth)acrylate monomers is well known in the art. In some embodiments, the olefin-alkyl (meth)acrylate copolymer may be one selected from random, block, multi-block, graft copolymers, and mixtures thereof.

In some embodiments, the ethylene-alkyl (meth)acrylate copolymer is represented by the following formula: 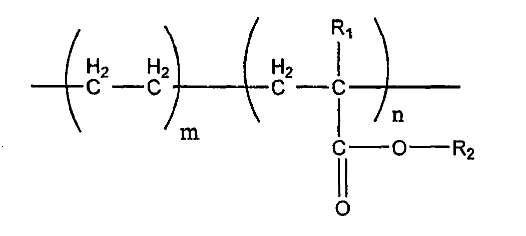 wherein R₁ is hydrogen or methyl, R₂ is hydrogen, methyl, ethyl, propyl, isopropyl, butyl, sec-butyl, t-butyl, isobutyl, isoamyl, or t-amyl, and the ratio of m to n ranges from about 300:1 to about 10:90.

In these embodiments, m and n monomer units may repeat in any fashion. In some embodiments, m monomer units are connected directly to other m monomer units. Alternatively, m monomer units can be adjacent to n monomer units. Thus, an ethylene-alkyl (meth)acrylate copolymer can for example consist of units mnmnmn, mmmnnmmm, mmmmnnnn, and so forth. Thus, the combination of m and n units can be in any arrangement in the ethylene-alkyl(meth)acrylate copolymer.

In some embodiments, the ethylene-alkyl (meth)acrylate copolymer will have a melt index of from about 0.1 to about 40 g per/10 minutes under conditions of 190° C and 2.16 kgf, and more preferably a melt index of 1 to 10 g per 10 minutes under the same conditions.

### Flame Retardant Agent Comprising An Antimony Compound

In embodiments, an additional flame retardant agent can act to increase the flame retardancy of the polymer composition.. In some embodiments, a brominated flame retardant compound is used. In some embodiments, chlorinated flame retardants may also be used. The degree of flame retardanacy exhibited by a particular embodiment will depend on the quantity of the halogen atoms in the flame retardant halogen-containing compound. In some embodiments, multiple compounds may share a bromine atom.

Examples of flame retardant halogen-containing compound include, but are not limited tetrabromobisphenol A, bis(tribromophenoxy)ethane, brominated epoxy resin, and brominated epoxy resin terminated with tribromophenol.

In some embodiments, the flame retardant agent can be used in an amount of 5-10 parts by weight based on 100 parts by weight of the rubber-modified styrenic copolymer resin. An advantage of this embodiment is that it provides sufficient flame retardancy. Another advantage is that processability and mechanical strength of the polymer composition and molds of the polymer composition can be maintained.

Antimony oxide may be used as a catalyst for the flame retardant halogen-containing compound. In certain embodiments, it synergistically acts with the flame retardant agent to provide sufficient flame retardancy. Examples of antimony oxide include antimony trioxide and antimony pentoxide.

In certain embodiments, the antimony component of the antimony compound can be used in an amount from about 0.1 to about 15 parts by weight, based on 100 parts by weight of the rubber-modified styrenic copolymer resin. More preferably, the weight of the antimony compound itself is used in an amount from about 1.0 to about 15 parts by weight, based on 100 parts by weight of the rubber-modified styrenic copolymer resin.

### Impact Modifier

An impact modifier is added to the polymer composition in order to provide additional advantageous properties. Even when using an impact modifier, the amount of the modifier can be minimized, while still providing excellent physical properties to the resulting composition.

The amount of impact modifier can be readily determined and modified depending on the particular modifier used and the properties desired in the resulting polymer composition. The physical properties of the compositions containing various amounts of impact modifier can be readily determined using the method for evaluation of physical properties discussed hereinbelow in connection with the examples. The impact modifier is provided in about 1 to about 10 parts by weight, and still more preferably about 2 to about 6 parts by weight, based on 100 parts by weight of the rubber-modified styrenic copolymer resin.

The impact modifier is a chlorinated organic compound. In other embodiments, the impact modifiers can be a chlorinated polymer. In some embodiments, the impact modifier may also serve to aid in the flame retardancy of the polymer composition. In some embodiments, the impact modifying chlorinated polymer may be a homopolymer or a copolymer. Examples of the impact modifying chlorinated polymer include, but are not limited to, chlorinated polyethylene and polyvinyl chloride.

In some embodiments, the polymer composition or the molded article may additionally contain halogen capture agent, a drop-preventing agent, a thermal stabilizer, an antioxidant, a light stabilizer, a compatibilizer, an organic or inorganic pigment, a dye, an inorganic filler, a metallic soap, wax, titanium dioxide, benotriazole, etc.

In these and other embodiments, a molded article or polymer composition may be prepared by any known method. For example, the inventive composition may be prepared by mixing the components of the compositions and other additives at the same time and melt-extruding the mixture through an extruder so as to prepare pellets. The mixture may also be molded into a shape and cure to form a molded article.

The invention is further described in terms of the following examples. All parts and percentage are by weight unless otherwise indicated.

### Examples

In the following examples, ABS resin is used as the rubber-modified styrenic copolymer resin. The ABS resin (A), the ethylene/alkyl(meth)acrylate copolymer (B), flame retardant agent (C), antimony oxide (D) and an impact modifier (E), which were used in Examples and Additional Examples below, have the following specification.

### (A) Rubber-modified Styrenic Copolymer Resin

An ABS resin having a butadiene rubber content of 17% by weight was used, which consists of 30 parts by weight of an ABS resin (PBD content: 58% by weight) prepared by graft polymerization using rubber having an average particle size of 0.32 µm and 70 parts by weight of a styrene-acrylonitrile (SAN) copolymer resin having a weight average molecular weight of 88,000, an acrylonitrile content of 28% by weight and a styrene content of 72% by weight.

### (B) Ethylene/alkyl(meth)acrylate copolymer

Two different ethylene/alkyl(meth)acrylate copolymers where studied:
(B₁) Elvaloy 3427 AC® (commercially available from Dupont, Inc., USA) having a melt index of 4.0 g/10 minutes under conditions of 190 °C and 2.16 kgf; and
(B₂) An ethylene/methacrylate copolymer having a melt index of 9.0 g/10 minutes under conditions of 190 °C and 2.16 kgf.
(C) Flame Retardant Agent
   SAYTEX RB 100 (Albermale Corporation, USA), a TBBA flame retardant having a weight average molecular weight of 550, was used.
(D) Antimony oxide
   Antimony trioxide (Il Sung Antimony Co., Ltd., Korea) was used.
(E) Impact Modifier
   Tyrin 3245P (DDE., Inc., USA), a chlorinated polyethylene (CPE), was used.

### Examples 1-4

Each of the components was added in the amount shown in Table 1 below, to which 1.0 part by weight of tin maleate compound TM-600P (Songwon Industrial Co., Ltd., Korea) as a halogen capture, 0.3 parts by weight of hindered phenol antioxidant Irganox 1076 (Songwon Industrial Co., Ltd., Korea) as an antioxidant, 0.4 parts by weight of SONGSTAB Ca-St (Songwon Industrial Co., Ltd., Korea) as a stearate metallic soap, and 1 part by weight of wax were added. The added components were uniformly mixed with each other and then extruded through a twin-screw extruder so as to prepare pellets.

### Additional Examples 1-5

Additional Example 1 was carried out in the same manner as in Example 1 except that the ethylene/alkyl(meth)acrylate copolymer was not used.

Additional Example 2 was used carried out in the same manner as in Example 1 except that the ethylene/alkyl(meth)acrylate copolymer and the impact modifier were not used.

Additional Example 3 was carried out in the same manner as in Example 1 except that the impact modifier was not used.

Additional Example 4 was carried out in the same manner as in Example 1 except that the ethylene/alkyl(meth)acrylate copolymer was not used and the impact modifier in an amount of 6 parts by weight.

Additional Example 5 was carried out in the same manner as in Example 1 except that the ethylene/alkyl(meth)acrylate copolymer was used in an amount of 6 parts by weight and the impact modifier was not used.

**(Table 1)**

| | | Examples | | | | Additional Examples | | | | |
|---|---|---|---|---|---|---|---|---|---|---|
| | | 1 | 2 | 3 | 4 | 1 | 2 | 3 | 4 | 5 |
| (A) Rubber-modified Styrenic Copolymer Resin | (A) | 100 | 100 | 100 | 100 | 100 | 100 | 100 | 100 | 100 |
| (B) | (B₁) | 3 | 10 | - | - | - | - | 3 | - | 6 |
| Ethylene/alkyl(meth)acrylate copolymer | (B₂) | - | - | 3 | 10 | - | - | - | - | - |
| (C) Flame Retardant Agent | | 22 | 22 | 22 | 22 | 22 | 22 | 22 | 22 | 22 |
| (D) Antimony oxide | | 6 | 6 | 6 | 6 | 6 | 6 | 6 | 6 | 6 |
| (E) Impact Modifier | | 3 | 3 | 3 | 3 | 3 | - | - | 6 | - |

From the pellets prepared as described above, test samples were prepared by injection molding. The test samples were measured for physical properties and flame retardancy, and the results are shown in Table 2 below.

**(Table 2)**

| Test items | Examples | | | | Additional Examples | | | | |
|---|---|---|---|---|---|---|---|---|---|
| | 1 | 2 | 3 | 4 | 1 | 2 | 3 | 4 | 5 |
| Notched Izod impact strength (kgf·cm/cm, 1/8",23 °C) | 20 | 25 | 19 | 24 | 10 | 7 | 13 | 16 | 19 |
| Melt index (g/10 min., 5 kg, 200 °C) | 15 | 14 | 15 | 14 | 15 | 15 | 15 | 14 | 14 |
| Vicat softening point (°C, 5 kg, 50 °C /hr) | 85 | 84 | 85 | 84 | 85 | 84 | 85 | 84 | 84 |
| Flame retardancy | V-0 | V-0 | V-0 | V-0 | V-0 | V-1 | V-1 | V-0 | V-1 |

The methods used for evaluation of physical properties were as follows:
(1) Impact strength: evaluated for a thickness of 1/8 inch in accordance with the test method of ASTM D-256 at 23 °C. The unit is kgf·cm/cm.
(2) Flowability: evaluated in accordance with the test method of ASTM D-1238 under conditions of a temperature of 200 °C and a load of 5 kg. The unit is g/10 min.
(3) Vicat softening point temperature: evaluated in accordance with ASTM D1525 at a load of 5 kg and a rate of 50 °C/hr. The unit is °C.
(4) Flame retardancy: tested and evaluated according to UL-94 flame retardant standards for a thickness of 1/12 inch.

As can be seen from the results of the physical properties of both the Examples and Additional Examples in Table 2 above, the embodiments of the present invention including both the rubber-modified styrenic copolymer resin and the ethylene/alkyl(meth)acrylate copolymer, maintained excellent flowability while showing a great increase in impact resistance, compared to Additional Examples 1, 2 and 4, in which the resin composition did not include the ethylene/alkyl(meth)acrylate copolymer.

It can also be seen from these results that the embodiments of the present invention in which both ethylene/alkyl(meth)acrylate copolymer and impact modifier are added to the rubber-modified styrenic copolymer show particularly unexpectedly advantageous results. In these embodiments, the ethylene/alkyl(meth)acrylate copolymer and impact modifier show synergistic effects by not only ensuring good flowability but also providing excellent impact resistance and flame retardancy.

As described above, certain embodiments provide the polymer composition which contains the rubber-modified styrenic copolymer resin in combination with the ethylene/alkyl(meth)acrylate copolymer and a flame retardant agent comprising an antimony compound. Such embodiments, have both good flowability and excellent impact resistance.

## Claims

1. A polymer composition comprising:
a rubber-modified styrenic copolymer resin;
an ethylene-alkyl (meth)acrylate copolymer resin; and
a flame retardant agent comprising an antimony compound and a chlorinated organic compound as an impact modifier, wherein the rubber-modified styrenic copolymer resin is present in an amount of about 100 parts by weight,
the ethylene-alkyl (meth)acrylate copolymer resin is present in an amount of about 0.1 to about 30 parts by weight,
the impact modifier is present in an amount of about 1 to about 10 parts by weight, and
the flame retardant agent is present in an amount of about 1 to about 25 parts by weight.

2. The polymer composition of Claim 1, wherein the ethylene-alkyl (meth)acrylate copolymer resin comprises a polymer represented by Formula (I): 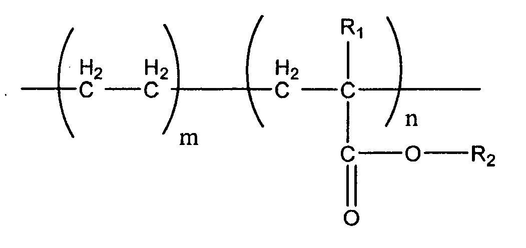
wherein R1 is hydrogen or methyl,
R2 is hydrogen, methyl, ethyl, propyl, isopropyl, butyl, sec-butyl, t-butyl, isobutyl, isoamyl, or t-amyl,
and the ratio of m to n ranges from about 300:1 to about 10:90.

3. The polymer composition of Claim 1, wherein the ethylene-alkyl (methyl) acrylate copolymer is made from at least one monomer selected from the group consisting of acrylate, methyl acrylate, ethyl acrylate, propyl acrylate,
isopropyl acrylate, butyl acrylate, sec-butyl acrylate, t-butyl acrylate, isobutyl acrylate, isoamyl acrylate, and t-amyl acrylate, methacrylate, methyl methacrylate, ethyl methacrylate, propyl methacrylate, isopropyl methacrylate, butylmethacrylate, sec-butyl methacrylate, t-butylmethacrylate, isobutyl methacrylate, isoamyl methacrylate, t-amyl methacrylate, and combinations thereof.

4. The polymer composition of Claim 1, wherein the polymer composition is substantially free of a polycarbonate.

5. The polymer composition of Claim 1, further comprising a polycarbonate up to about 15% with reference to the total weight of the composition.

6. The polymer composition of Claim 1, wherein the impact modifier is selected from a group consisting of polyvinyl chloride, chlorinated polyethylene, and combinations thereof.

7. The polymer composition of Claim 1, wherein the flame retardant agent is selected from the group consisting of tetrabromobisphenol A, bis(tribromophenoxy) ethane, brominated epoxy resin, brominated epoxy resin terminated with tribromophenol, and combinations thereof.

8. A molded article comprising the polymer composition of Claim 1.

9. The molded article of Claim 8, wherein the composition has a flame retardancy of V-0 when a specimen of the composition is tested according to UL-94 flame retardant standards for a specimen thickness of 1/12".

10. The molded article of Claim 8, wherein the polymer composition has an impact strength of at least about 19 kgf·cm/cm when a specimen of the composition is tested according to the standard ASTM D256 (1/8" notched) at 23 °C.

11. The molded article of Claim 8, wherein the polymer composition has a melt index of at least 14 g/10 minutes when a specimen of the composition is tested according to the standard ASTM D-1238 (200 °C and 5 kg).

12. The molded article of Claim 8, wherein the polymer composition has a Vicat softening point temperature of at least about 84 °C when a specimen of the composition is tested according to ASTM D1525 at a load of 5 kg and a rate of 50 °C/hr.

13. A method of making a plastic structure, the comprising:
providing the polymer composition of Claim 1; and
molding the polymer composition into a shape.

14. Use of the polymer composition of Claim 1 in an electronic device, comprising an electronic circuit and a housing substantially enclosing the electronic circuit, the housing comprising a portion, which comprises the polymer composition of Claim 1.

15. Use of a polymer composition of Claim 1 in an electronic device, comprising a housing, wherein the housing comprises a portion comprising the polymer composition of Claim 1.

## Patentansprüche

1. Eine Polymerzusammensetzung enthaltend:
- ein kautschukhaltiges Styrol-Copolymerharz;
- ein Ethylen-Alkyl (Meth)Acrylat-Copolymerharz; und
- ein flammhemmendes Agens enthaltend eine Antimonverbindung und eine chlorierte organische Verbindung als ein Schlagzähmodifizierer, wobei das kautschukhaltige Styrol-Copolymerharz in einer Menge von ca. 100 Gewichtsteilen vorhanden ist, dass Ethylen-Alkyl (Meth)Acrylat-Copolymerharz in einer Menge von ungefähr 0,1 bis ungefähr 30 Gewichtsteilen, der Schlagzähmodifizierer in einer Menge von ungefähr 1 bis ungefähr 10 Gewichtsteilen und das flammhemmende Agens in einer Menge von ungefähr 1 bis ungefähr 25 Gewichtsteilen.

2. Die Polymerzusammensetzung von Anspruch 1, wobei das Ethylen-Alkyl (Meth)Acrylat-Copolymerharz ein Polymer enthält dargestellt durch die Formel (I): 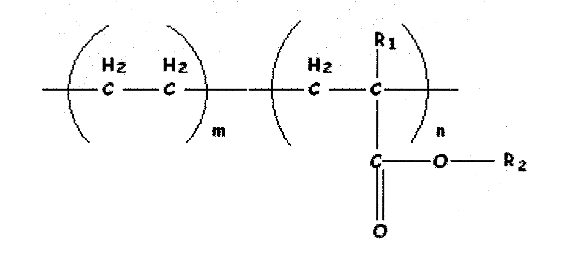
wobei R1 Wasserstoff oder Methyl,
R2 Wasserstoff, Methyl, Ethyl, Propyl, Isopropyl, Butyl, sec-Butyl, t-Butyl, Isobutyl, Isoamyl oder t-Amyl ist und das Verhältnis von m zu n in einem Bereich von ungegfähr 300:1 zu ungefähr 10:90 liegt.

3. Die Polymerzusammensetzung von Anspruch 1, wobei das Ethylen-Alcyl (Methyl)Acrylat-Copolymer aus mindestens einem der Monomeren hergestellt ist ausgewählt von der Gruppe enthaltend Acrylat, Metyl-Acrylat, Ethyl-Acrylat, Propyl-Acrylat, Isopropyl-Acrylat, Butyl-Acrylat, sec-Butyl-Acrylat, t-Butyl-Acrylat, Isobutyl-Acrylat, Isoamyl-Acrylat und t-Amyl-Acrylat, Methylakrylat, Methyl-Methacrylat, Ethyl-Methacrylat, PropylMethacrylat, Isopropyl-Methacrylat, Butylmethacrylat, sec-Butyl-Methacrylat, t-Butylmethacrylat, Isobutyl-Methacrylat, IsoamylMethacrylat, t-Amyl-Methacrylat und Kombinationen davon.

4. Polymerzusammensetzung von Anspruch 1, wobei die Polymerzusammensetzung weitgehendst frei ist von Polycarbonat.

5. Polymerzusammensetzung von Anspruch 1, weiter enthaltend ein Polycarbonat bis zu ungefähr 15% in Bezug auf das totale Gewicht der Zusammensetzung.

6. Polymerzusammensetzung nach Anspruch 1, wobei der Schlagzähmodifizierer ausgewählt ist von einer Gruppe bestehend aus Polyvinylchlorid, chloriertem Polyethylen, und Kombinationen davon.

7. Polymerzusammensetzung nach Anspruch 1, wobei das flammhemmende Agens ausgewählt ist aus der Gruppe bestehend aus Tetrabromobisphenol A, bis (Tribromophenoxy)Ethan, bromiertem Epoxydharz, bromiertem Epoxydharz beendet mit Tribromophenol, und Kombinationen davon.

8. Ein geformter Artikel enthaltend die Polymerzusammensetzung von Anspruch 1.

9. Der geformte Artikel von Anspruch 8, wobei die Zusammensetzung eine Flammhemmung von V-0 aufweist wenn ein Prüfkörper der Zusammensetzung gemäss UL-94 Flammhemmungsstandards für Prüfkörper der Dicke von 1/12" gestestet wird.

10. Der geformte Artikel von Anspruch 8, wobei die Polymerzusammensetzung eine Schlagzähigkeit aufweist von mindestens ungefähr 19 kgf·cm/cm wenn ein Prüfkörper der Zusammensetzung gemäss dem Standard ASTM D256 (1/8" gekerbt) bei 23°C getestet wird.

11. Der geformte Artikel von Anspruch 8, wobei die Polymerzusammensetzung einen Schmelzindex von mindestens 14g/10 Min. aufweist wenn ein Prüfkörper der Zusammensetzung gemäss dem Standard ASTM D-1238 (200°C und 5kg) getestet wird.

12. Der geformte Artikel nach Anspruch 8, wobei die Polymerzusammensetzung eine Vicat-Erweichungstemperatur aufweist von mindestens ungefähr 84°C wenn ein Prüfkörper der Zusammensetzung gemäss ASTM D1525 um einer Belastung von 5kg und einer Messrate von 50°C/Std. getestet wird.

13. Verfahren zur Herstellung einer Kunststoffstruktur aufweisend:
Bereitstellen der Polymerzusammensetzung von Anspruch 1;
giessen der Polymerzusammensetzung in eine Form.

14. Verwendung der Polymerzusammensetzung von Anspruch 1 in einem elektronischen Gerät enthaltend einen elektronischen Schaltkreis und ein Gehäuse weitgehendst einschliessend den elektronischen Schaltkreis, das Gehäuse aufweisend einen Bereich welcher die Polymerzusammensetzung von Anspruch 1 enthält.

15. Verwendung einer Polymerzusammensetzung von Anspruch 1 in einem elektronischen Gerät enthaltend ein Gehäuse, wobei das Gehäuse einen Bereich aufweist enthaltend die Polymerzusammensetzung von Anspruch 1.

## Revendications

1. Une composition de polymère comprenant:
une gomme-modifiée styrène copolymère résine;
une éthylène-alkyle(méth)acrylate copolymère résine; et
un agent ignifuge comprenant un composé antimoine et un composé organique chloré comme modifiant à résistance élevée aux chocs, la résine gomme-modifiée styrène copolymère résine étant présent de quantité d'environ 100 parts par poids,
l'éthylène-alkyle(méth)acrylate copolymère résine étant présent de quantité d'environ 0.1 à environ 30 parts par poids,
le modifiant à résistance élevée aux chocs étant présent de quantité d'environ 1 à 10 parts par poids, et
l'agent ignifuge étant présent de quantité d'environ 1 à environ 25 parts par poids.

2. La composition de polymère selon la revendication 1, le éthylène-alkyle(méth)acrylate copolymère résine comprend un polymère représenté par la formule (I): 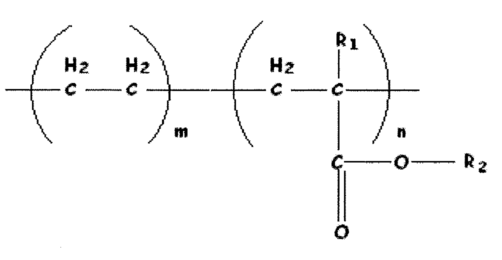 étant
R1
hydrogène ou méthyle,
R2 étant hydrogène, méthyle, éthyle, propyle, isopropyle, butyle, sec-butyle, t-butyle, isobutyle, isoamyle ou t-amyle,
et le rapport de m à n s'étend environ 300:1 jusqu'à environ 10:90.

3. La composition de polymère selon la revendication 1, l'éthylène-alkyle(méthyle)acrylate copolymère étant fait d'au moins un monomère sélecté du group consistant d'acrylate, méthyle acrylate, éthyle acrylate, propyle acrylate, isopropyle acrylate, butyle acrylate, sec-butyle-acrylate, t-butyl-acrylate, isobutyle-acrylate, isoamyle acrylate, et t-amyle-acrylate, méthacrylate, méthyle méthacrylate, éthyl méthacrylate, propyle méthacrylate, isopropyle méthacrylate, butylméthacrylate, sec-butyle méthacrylate, t-butylméthacrylate, isobutyle méthacrylate, isoamyle méthacrylate, t-amyle méthacrylate, et des combinaisons de ceux-ci.

4. La composition de polymère selon la revendication 1, la composition de polymère étant essentiellement libre d'un polycarbonate.

5. La composition de polymère selon la revendication 1, de plus comprenant un polycarbonate jusqu'à environ 15% par rapport au poids total de la composition.

6. La composition de polymère selon la revendication 1, le modifiant à résistance élevée aux chocs étant sélecté d'un group consistant du polyvinyle chloride, polyéthylène chloré, et des combinaisons de ceux-ci.

7. La composition de polymère selon la revendication 1, l'agent ignifuge étant sélecté du group consistant de tetrabromobisphénole A, bis(tribromophénoxy)éthane, époxy résine bromée, époxy résine bromée terminée avec du tribromophénole, et des combinaisons de ceux-ci.

8. Un article moulé comprenant le polymère selon la composition de la revendication 1.

9. L'article moulé selon la revendication 8, la composition ayant une propriété ignifuge de V-0 quand un spécimen de la composition est testé selon des standards ignifuges UL-94 pour un spécimen de l'épaisseur 1/12".

10. L'article moulé selon la revendication 8, la composition polymère ayant une résilience d'environ au moins 19kgf·cm/cm quand un spécimen de la composition est testé selon le standard ASTM D256 (1/8" crénelé) à 23°C.

11. L'article moulé selon la revendication 8, la composition polymère ayant un index fusion d'au moins 14 g/10 minutes quand un spécimen de la composition est testé selon le standard ASTM D-1238 (200 °C et 5 kg).

12. L'article moulé selon la revendication 8, la composition polymère ayant une température de ramollissement Vicat d'au moins 84 °C quand un spécimen de la composition est testé selon ASTM D1525 sur une charge de 5kg et d'une cadence de mesure de 50 °C/h.

13. Un procédé pour produire une structure plastique comprenant:
préparer la composition selon la revendication 1; et
mouler la composition de polymère dans une moule.

14. Utilisation de la composition de polymère selon la revendication 1 dans un appareil électronique, comprenant un circuit électronique et une boîte enclavant essentiellement le circuit électronique, la boîte comprenant une portion qui comprend la composition de polymère selon la revendication 1.

15. Utilisation de la composition de polymère selon la revendication 1 dans un appareil électronique, comprenant une boîte, la boîte comprenant une portion comprenant la composition de polymère selon la revendication 1.
